## Europäisches Patentamt
## European Patent Office
## Office européen des brevets

(19)

(11) Numéro de publication: **0 128 079**
**B1**

# FASCICULE DE BREVET EUROPÉEN

(12)

(45) Date de publication du fascicule du brevet:
21.09.88

(21) Numéro de dépôt: **84401053.8**

(22) Date de dépôt: **22.05.84**

(51) Int. Cl.⁴: **H 01 L 23/54**, H 01 L 23/56, H 01 L 23/04

(54) **Boîtier d'encapsulation de composant électronique, durci vis-à-vis des radiations.**

(30) Priorité: **03.06.83 FR 8309288**

(43) Date de publication de la demande:
**12.12.84 Bulletin 84/50**

(45) Mention de la délivrance du brevet:
**21.09.88 Bulletin 88/38**

(84) Etats contractants désignés:
**DE FR GB IT NL SE**

(56) Documents cité:
**FR-A-2 495 837**
**US-A-4 249 196**
**US-A-4 323 405**

**MANUFACTURING TECHNOLOGY NOTE, U.S. ARMY MATERIEL DEVELOPMENT AND READINESS COMMAND, rapport no. HDL-CR-75-216-1, décembre 1980, page PB81-970510, Alexandria, US; "Packaging radiation-hardened semiconductor wafers"**
**PATENTS ABSTRACTS OF JAPAN, vol. 5, no. 103 (E-64) 775, 3 juillet 1981**

(73) Titulaire: **THOMSON- CSF, 173, Boulevard Haussmann, F-75379 Paris Cédex 08 (FR)**

(72) Inventeur: **Boccon, Gibod Yves, THOMSON- CSF SCPI 173, bld Haussmann, F-75379 Paris Cedex 08 (FR)**
Inventeur: **Pinel, Joseph, THOMSON- CSF SCPI 173, bld Haussmann, F-75379 Paris Cedex 08 (FR)**
Inventeur: **Val, Christian, THOMSON- CSF SCPI 173, bld Haussmann, F-75379 Paris Cedex 08 (FR)**

(74) Mandataire: **Benoit, Monique, THOMSON- CSF SCPI 19, avenue de Messine, F-75008 Paris (FR)**

EP 0 128 079 B1

LIBER, STOCKHOLM 1988

## Description

La présente invention a pour objet un boîtier d'encapsulation de composant électronique qui est "durci" vis-a-vis des radiations, notamment ionisantes, c'est-à-dire un boîtier qui réalise la protection du composant qu'il contient contre ces radiations.

Dans la description suivante, on désignera pour simplifier par "composant" tout composant discret ou ensemble de composants formant un circuit hybride ou intégré, susceptible d'être encapsulé dans un boîtier.

La réalisation d'équipements électroniques performants tant sur le plan de la vitesse de traitement que de la capacité ou de la compacité, tels que des calculateurs embarqués, nécessite des circuits complexes, rapides et à haut degré d'intégration du type LSI (pour "Large Scale Integration") ou VLSI (pour "Very Large Scale Integration"). Or ces circuits sont très sensibles aux effets des radiations, plus particulièrement à ceux qui résultent de l'ionisation.

Pour limiter ces effets, deux techniques de protection, ou de "durcissement", sont habituellement mises en oeuvre. La première consiste à réaliser un blindage extérieur de l'équipement complet, à l'aide par exemple de feuilles d'un métal convenablement choisi. Ses inconvénients sont principalement le poids et l'encombrement, particulièrement gênants pour des matériels embarqués. Selon la deuxième technique, on choisit pour réaliser l'équipement des composants et/ou des circuits résistant aux radiations; de tels composants et circuits existent à l'heure actuelle mais en petit nombre et leur durcissement est le résultat à la fois des règles de conception utilisées (prenant notamment en compte les variations de parametres et les dégradations provoquées par les radiations) et des technologies choisies. Toutefois ces circuits ne sont pas assez performants pour certaines applications, notamment sur le plan des degrés d'intégration atteints; de plus, leur réalisation en technologie durcie exige parfois des délais extrêmement longs; leur coût, enfin, est très élevé.

Le document FR-A-2 495 837 décrit un condensateur de découplage sérigraphié sur l'embase d'un boîtier de composant électronique. Pour assurer la protection de ce composant contre le rayonnement α, il propose de réaliser les électrodes du condensateur en un métal lourd et le diélectrique en titanate de baryum.

Le document US-A-4 249 196 décrit un condensateur incorporé au capot d'un boîtier de composant électronique.

La présente invention permet d'éviter ces inconvénients en réalisant un durcissement au niveau des boîtiers d'encapsulation des composants et circuits utilisés dans l'équipement à protéger.

Plus précisément, le boîtier selon l'invention est défini par la revendication 1.

D'autres objets, caractéristiques et résultats de l'invention ressortiront de la description suivante, illustrée par les dessins annexés qui représentent:
-la figure 1, le schéma d'un boîtier pour composant électronique;
-la figure 2, un premier mode de réalisation du dispositif selon l'invention;
-la figure 3, une variante de la figure précédente;
-la figure 4, un deuxième mode de réalisation du dispositif selon l'invention;
-la figure 5, un troisième mode de réalisation du dispositif selon l'invention;
-la figure 6, un quatrième mode de réalisation du dispositif selon l'invention.

Sur ces différentes figures, d'une part l'échelle réelle n'a pas été respectée à des fins de clarté et, d'autre part, les mêmes références se rapportent aux mêmes éléments.

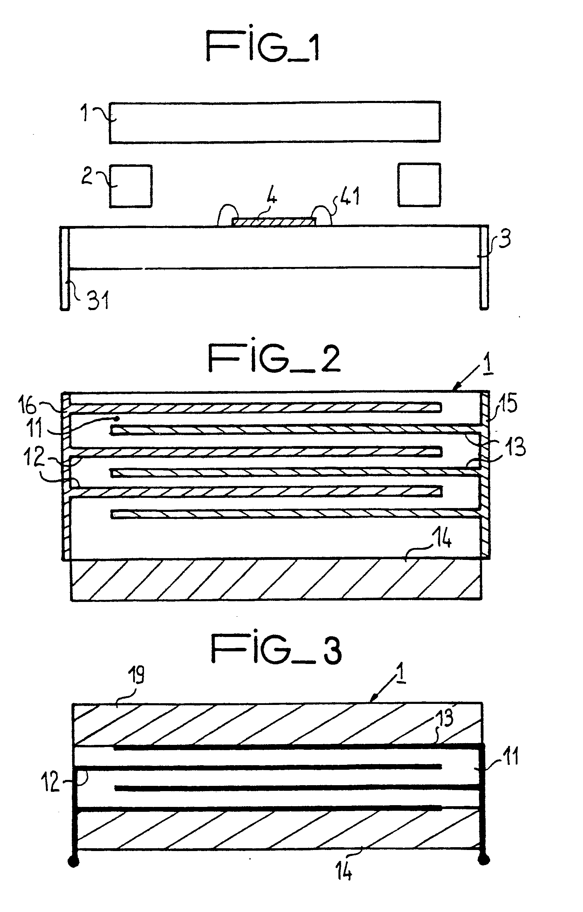

Sur la figure 1, on a donc schématisé, vu en coupe, un boîtier de composant ou de circuit hybride ou intégré, qui comporte une embase 3, où est fixée par exemple une pastille semiconductrice 4 dans laquelle est réalisé le composant, et un capot 1 venant se fixer sur l'embase 3, par l'intermédiaire d'une partie latérale 2.

Suivant les types de boîtiers (DIL, Cerdip, "chip carrier", etc..., plan ou à plusieurs niveaux), la partie latérale 2 est solidaire soit de l'embase 3, soit du capot 1.

Le composant 4 est fixé sur la face supérieure de l'embase 3, par exemple par brasure sur une métallisation non représentée; ses points de connexion sont reliés (connexion 41) à des pistes conductrices (non représentées) qui aboutissent à des moyens de connexion électrique vers l'extérieur du boîtier, par exemple des broches 31.

La figure 2 représente un mode de réalisation d'un boîtier selon l'invention, dans lequel le durcissement est réalisé au niveau du capot (1).

Ce capot comporte au moins deux matériaux distincts, 11 et 12 - 13, disposés chacun en au moins une couche, l'un des matériaux (11) ayant un nombre de charges atomiques $Z_1$ élevé par rapport au nombre de charges $Z_2$ de l'autre matériau (12 - 13).

En effet, ainsi qu'il est connu, les matériaux à nombre de charges élevé permettent d'atténuer les rayonnements fortement ionisants, tels que rayons X et γ. Toutefois, cette atténuation entraîne la production d'un flux d'électrons qu'il est souhaitable également d'atténuer autant que possible. Pour cela, un matériau à nombre de charges plus faible est préférable: il est en effet suffisant sur le plan énergétique, plus léger, répondant ainsi au critère de poids énoncé plus haut, et faiblement émissif d'électrons selon l'invention, un tel matériau est utilisé pour constituer la face interne du capot, c'est-à-dire celle qui est située vers le composant.

On entend dans la présente description par nombre de charge élevé, un nombre au moins égal à 35, et par un nombre de charge faible, un nombre au plus égal à 20.

Dans le mode de réalisation représenté figure 2, on a disposé plusieurs couches de chacun des matériaux afin d'améliorer l'efficacité du dispositif.

En outre, on peut choisir les matériaux et disposer les couches de façon à réaliser un condensateur: le premier matériau, 11, à nombre $Z_1$ élevé, est alors un diélectrique et le second matériau, a nombre $Z_2$ faible, est dispose en au moins deux couches, respectivement 12 et 13, encadrant le diélectrique 11, formant les armatures du condensateur. Dans le mode de réalisation de la figure 2, on a réalisé un condensateur multicouches à six armatures reliées par des conducteurs extérieurs 15 et 16. Un tel condensateur peut avantageusement constituer un condensateur de découplage comme il en est généralement requis pour ce genre de boîtier.

Enfin, il est possible, comme représenté sur la figure 2, d'ajouter une couche supplémentaire 14, sur la face intérieure du capot 1, d'un matériau dont le nombre de charges $Z_3$ est faible. Cette variante permet plus de souplesse dans le choix des matériau 12 - 13 et 11, qui peuvent être alors de nombre de charges moyen élevé.

En ce qui concerne le choix des matériaux, le matériau à nombre de charges faible peut être l'un des corps suivants: carbone, aluminium, silicium, alumine et silice, étant entendu que, pour réaliser des électrodes, le matériau doit être choisi en outre conducteur de l'électricité; le matériau à nombre de charges élevé peut être un matériau composite comportant au moins un corps dont le nombre de charges est élevé, tel qu'une céramique diélectrique, choisie soit dans la famille des titanates, par exemple titanate de baryum modifié (avec des métaux lourds) ou titanate de néodyne (également modifié), soit dans la famille des oxydes, par exemple l'oxyde de titane (modifié également), soit encore une ceramique complexe à base de plomb.

A titre d'exemple, le matériau 11 peut être du titanate de baryum ($BaTiO_3$) ou un oxyde de néodyne; dans le cas où on dispose une couche supplémentaire 14, qui peut être par exemple en alumine ($Al_2O_3$), les armatures 12 et 13 peuvent être réalisées en un matériau à nombre $Z_2$ élevé, tel que métaux ou alliages à base d'argent et de palladium.

La figure 3 représente une variante de la figure précédente qui comporte une couche 19 supplémentaire, de préférence réalisée dans le même matériau que la couche 14, afin d'améliorer la faisabilité technologique.

En effet, il est difficile d'avoir des matériaux différents ayant les mêmes coefficients de dilatation thermique; si ceuz-ci sont trop différents, la fabrication du capot, impliquant couramment une assez forte température (plus de 1000°), on obtient un élément qui n'est pas plan; le fait de symétriser la structure par une couche 19 de mêmes caractéristiques thermiques (par exemple d'un matériau identique) que la couche 14 permet de corriger ce défaut.

La figure 4 représente un autre mode de réalisation dans lequel le capot 1 et la partie latérale 2 sont solidaires pour former un capot 5, l'ensemble de celui-ci étant durci.

Les mêmes variantes que précédemment peuvent être réalisées pour la partie 1 du capot 5.

La partie latérale 2 est, dans ce mode de réalisation, constituée par le matériau 11, à nombre $Z_1$ élevé, recouverte sur sa face interne par la couche 14, à nombre $Z_3$ faible.

Il est à noter que la partie latérale 2 peut être durcie de cette façon, indépendamment de la partie 1 du capot, qui peut alors être ou non durcie, comporter ou non un condensateur.

La figure 5 représente un autre mode de réalisation du boîtier selon l'invention, dans lequel le durcissement est réalisé au niveau de sa partie latérale 2.

Celleci comporte, comme la partie 1 sur la figure 2, un condensateur avec son diélectrique 21 et ses armatures 22 et 23, reliées entre elles le cas échéant (condensateur multicouche) et connectées à l'extérieur par des connexions 25 et 26, les éléments 21, 22, 23, 25 et 26 étant analogues aux éléments 11, 12, 13, 15 et 16 de la figure 2.

Les couches 21, 22 et 23 peuvent être réalisées parallèlement aux capot 1 et à l'embase 3, comme représenté sur la figure, ou bien à 90° de façon à interposer leur grande surface entre le rayonnement à atténuer et le composant 4.

Dans ce mode de réalisation, le capot 1 peut être non durci ou durci selon l'une des variantes précédentes, avec ou sans réalisation d'un condensateur.

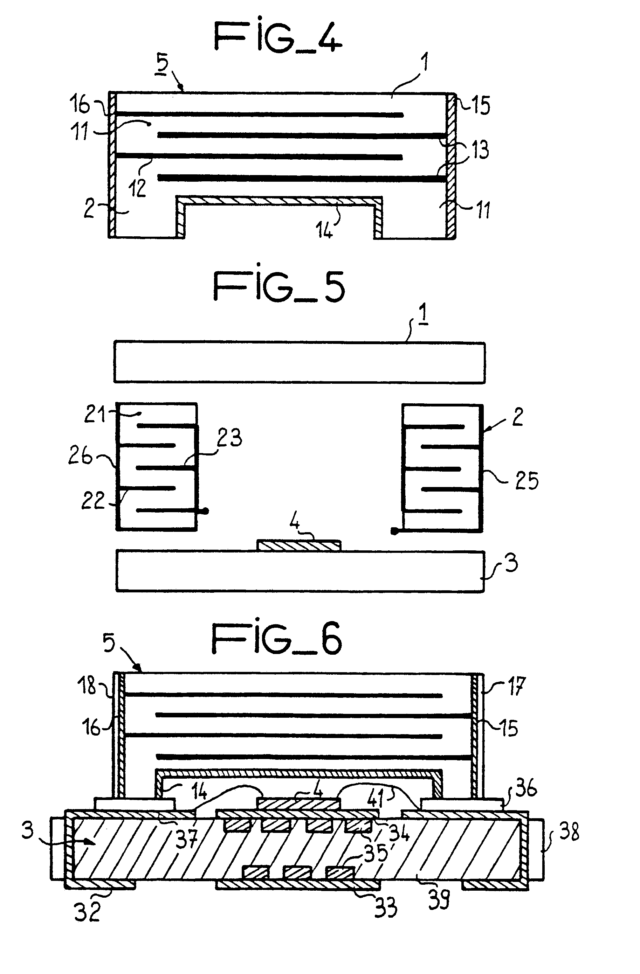

La figure 6 représente un autre mode de réalisation de l'invention dans lequel l'embase (3) du boîtier est durcie.

A titre d'exemple, le boîtier est d'un type connu sous le nom "chip carrier", qui présente la particularité d'être dépourvu de broches de connexion, celles-ci étant remplacées par de simples métallisations 32 sur la partie inférieure de l'embase 3. A titre d'exemple toujours, l'embase de ce boîtier est plane.

Le capot 5 est par exemple durci et identique à celui de la figure 4. Les connexions 15 et 16 reliant les armatures du condensateur sont par exemple réalisées dans des demi-trous 17 et 18 respectivement, comme il est habituellement fait au niveau de l'embase d'un "chip carrier". Le capot 5 est scellé (36) sur l'embase 3.

L'embase 3 porte donc le composant 4, fixé sur une couche métallique 34. Il est connecté (liaisons 41) classiquement à des pistes 37 disposées sur l'embase 3 et se prolongeant par des demi- trous 38 jusqu'aux métallisations 32.

Selon l'invention, l'embase 3 comporte également, à des fins de durcissement, une alternance de matériaux à fort et faible nombre de charges, choisis et disposés de telle sorte qu'ils répondent aux contraintes s'exerçant habituellement sur les embases de boîtier, à savoir principalement l'adaptation du coefficient de dilatation thermique de l'embase 3 à celui du semiconducteur 4 et une bonne conductivité thermique pour l'évacuation de la puissance dissipée par le composant. A cet effet, l'embase 3 est réalisée en un matériau (39) à faible nombre de charges, de l'alumine par exemple, tel que le tungstène, sur sa face externe (inférieure), entre les métallisations 32.

De préférence, la couche 34 sur laquelle est fixé le composant est également réalisée en un matériau à nombre de charges faible.

Dans la variante représentée sur la figure 6, il est en outre réalisé dans l'embase 3, sur ses deux grandes faces, des inclusions 35 en un matériau à la fois thermiquement bon conducteur et à nombre de charges élevé. Ici encore, le tungstène convient.

Dans l'un ou l'autre des modes de réalisation décrits ci-dessus, il peut être avantageux d'éviter une transition brutale entre matériau à nombre Z fort et matériau à nombre Z faible, notamment en vue d'éviter les chocs thermiques à l'interface des deux matériaux lorsque les radiations subies sont intenses. Cette transition douce peut être réalisée à l'aide de matériaux différents, à nombre Z intermédiaire, ou, de préférence, par alliage ou composition des deux matériaux en cause (par exemple, composition céramique incluant un pourcentage croissant de matériau à nombre Z fort ou faible).

La description faite ci-dessus ne l'a été qu'à titre d'exemple non limitatif. C'est ainsi par exemple que le condensateur réalisé dans le capot peut l'être à l'aide de matériaux à nombre de charges faible, une couche à nombre de charges élevé étant alors disposée sur la face externe du capot.

**Revendications**

1. Boîtier d'encapsulation de composant électronique, comportant une embase (3) pour recevoir le composant (4) et un capot (1) fixé sur l'embase (3) par l'intermédiaire d'une partie latérale (2), au moins l'un des éléments précédents comportant au moins deux couches de matériaux distincts, ledit boîtier étant caractérisé par le fait que le premier des matériaux distincts comporte un élément ayant un nombre de charges atomiques (Z) élevé de sorte à atténuer substantiellement les rayonnements, et que le ou les éléments constituant le deuxième des matériaux distincts, situé le plus à l'intérieur du boîtier, a ou ont un nombre de charges faible de sorte à atténuer substantiellement le flux d'électrons formé dans le premier matériau.

2. Boîtier selon la revendication 1, caractérisé par le fait que le matériau le plus extérieur à un nombre de charges élevé et que l'autre matériau à un nombre de charges faible.

3. Boîtier selon la revendication 1, caractérisé par le fait que l'élément est le capot.

4. Boîtier selon l'une des revendications précédentes, caractérisé par le fait que le premier des matériaux (11) est isolant et le deuxième (12, 13) est conducteur de l'électricité, ce deuxième matériau étant disposé en au moins deux couches, de part et d'autre du premier matériau, l'ensemble formant un condensateur, et qu'il comporte une couche supplémentaire (14), disposée sur sa face interne, dont le nombre de charges est faible.

5. Boîtier selon la revendication 4, caractérisé par le fait que les deux matériaux sont chacun disposés en une pluralité de couches alternées, formant ainsi un condensateur multicouches.

6. Boîtier selon la revendication 5, caractérisé par le fait que l'élément comporte une couche supplémentaire, disposée sur sa face externe, réalisée en un matériau ayant sensiblement les mêmes caractéristiques thermiques que la couche supplémentaire interne.

7. Boîtier selon l'une des revendications précédentes, caractérisé par le fait que l'élément comporte une couche supplémentaire, disposée sur sa face externe, dont le nombre de charges est élevé.

8. Boîtier selon les revendications 3 et 4, 5, 6 ou 7, caractérisé par le fait que sa partie latérale (2) est réalisée en un matériau (11) à nombre de charges élevé et comporte une couche (14) disposée sur sa face interne, dont le nombre de charges est faible par rapport au précédent.

9. Boîtier selon l'une des revendications 3 et 4, 5, 6, 7 ou 8, caractérisé par le fait que son embase (3) est réalisée en un matériau dont le nombre de charges est faible et comporte une couche (33) disposée sur sa face externe, dont le nombre de charges est élevé par rapport au précédent.

10. Boîtier selon la revendication 9, caractérisé par le fait que l'embase (3) comporte en outre une couche métallique (34) à nombre de charges faible, disposée sur sa face interne, couche (34) sur laquelle est fixé le composant (4).

11. Boîtier selon l'une des revendications 9 ou 10, caractérisé par le fait que l'embase (3) comporte, réalisées dans le matériau à nombre de charges faible, des inclusions sur ses faces interne et externe, réalisées en un matériau à bonne conductivité thermique et à nombre de charges élevé.

12. Boîtier selon l'une des revendications précédentes, caractérisé par le fait que la transition entre les matériaux à nombre de charges différents est réalisée doucement.

13. Boîtier selon l'une des revendications précédentes, caractérisé par le fait que le matériau à nombre de charges faible a un nombre de charges au plus égal à 20.

14. Boîtier selon l'une des revendications précédentes, caractérisé par le fait que le matériau à nombre de charges faible est choisi dans le groupe suivant: carbone, aluminium, silicium, alumine, silice.

15. Boîtier selon l'une des revendications précédentes, caractérisé par le fait que le matériau à nombre de charges élevé a un nombre de charges au moins égal à 35.

16. Boîtier selon l'une des revendications précédentes, caractérisé par le fait que le matériau à nombre de charges élevé est une céramique diélectrique choisie dans la famille des titanates, dans la famille des oxydes ou dans la famille des céramiques complexes à base de plomb.

**Patentansprüche**

1. Gehäuse zum Einkapseln von elektronischen Bauteilen mit einem das Bauteil (4) tragenden Sockel (3) und einer Haube (1), die durch ein Seitenteil (2) an dem Sockel (3) befestigt ist, wobei wenigstens eines der vorstehenden Elemente wenigstens zwei Schichten aus verschiedenen Stoffen umfaßt, wobei das genannte Gehäuse dadurch gekennzeichnet ist, daß der erste der verschiedenen Stoffe ein Element umfaßt, das eine hohe Atomladungszahl (Z) aufweist, so daß Strahlungen wesentlich abgeschwächt werden, und daß das oder die Elemente, welche den zweiten der verschiedenen Stoffe bilden, der sich am weitesten innerhalb des Gehäuses befindet, eine geringe Ladungszahl hat oder haben, so daß der in dem ersten Stoff gebildete Elektronenfluß wesentlich abgeschwächt wird.

2. Gehäuse nach Anspruch 1, dadurch gekennzeichnet, daß der am weitesten außenliegende Stoff eine hohe Ladungszahl aufweist und daß der andere Stoff eine kleine Ladungszahl aufweist.

3. Gehäuse nach Anspruch 1, dadurch gekennzeichnet, daß das Element die Haube ist.

4. Gehäuse nach einem der vorstehenden Ansprüche, dadurch gekennzeichnet, daß der erste der Stoffe (11) isolierend ist und daß der zweite (12, 13) stromleitend ist, wobei dieser zweite Stoff in wenigstens zwei Schichten beiderseits des ersten Stoffes angeordnet ist und diese Gruppe einen Kondensator bildet, und daß es eine auf seiner Innenseite angeordnete zusätzliche Schicht (14) umfaßt, deren Ladungszahl klein ist.

5. Gehäuse nach Anspruch 4, dadurch gekennzeichnet, daß jeder der beiden Stoffe in einer Vielzahl von abwechselnden Schichten angeordnet ist und dabei ein mehrschichtiger Kondensator gebildet wird.

6. Gehäuse nach Anspruch 5, dadurch gekennzeichnet, daß das Element eine zusätzliche Schicht umfaßt, die auf seiner Außenseite angeordnet ist und aus einem Stoff besteht, der im wesentlichen dieselben thermischen Eigenschaften wie die zusätzliche Innenschicht aufweist.

7. Gehäuse nach einem der vorstehenden Ansprüche, dadurch gekennzeichnet, daß das Element eine zusätzliche Schicht umfaßt, die auf seiner Außenseite angeordnet ist und deren Ladungszahl hoch ist.

8. Gehäuse nach den Ansprüchen 3 und 4, 5, 6 oder 7, dadurch gekennzeichnet, daß sein Seitenteil (2) aus einem Stoff (11) mit hoher Ladungszahl gebildet ist und eine auf seiner Innenseite angeordnete Schicht (14) umfaßt, deren Ladungszahl gegenüber den vorausgehenden klein ist.

9. Gehäuse nach einem der Ansprüche 3 und 4, 5, 6, 7 oder 8, dadurch gekennzeichnet, daß sein Sockel (3) aus einem Stoff gebildet ist, dessen Ladungszahl klein ist, und eine auf seiner Außenseite angeordnete Schicht (33) umfaßt, deren Ladungszahl gegenüber den vorausgehenden hoch ist.

10. Gehäuse nach Anspruch 9, dadurch gekennzeichnet, daß der Sockel (3) ferner eine Metallschicht (34) mit kleiner Ladungszahl umfaßt, die auf seiner Innenseite angeordnet ist und an welcher das Bauteil (4) befestigt ist.

11. Gehäuse nach den Ansprüchen 9 oder 10, dadurch gekennzeichnet, daß der Sockel (3) auf seinen Innen- und Außenseiten Einschlüsse umfaßt, die in dem Stoff mit kleiner Ladungszahl gebildet und aus einem Stoff mit guter thermischer Leitfähigkeit sowie hoher Ladungszahl gebildet sind.

12. Gehäuse nach einem der vorstehenden Ansprüche, dadurch gekennzeichnet, daß der Übergang zwischen den Stoffen mit verschiedener Ladungszahl gleitend ist.

13. Gehäuse nach einem der vorstehenden Ansprüche, dadurch gekennzeichnet, daß der Stoff mit kleiner Ladungszahl eine Ladungszahl, die höchstens 20 gleich ist, aufweist.

14. Gehäuse nach einem der vorstehenden Ansprüche, dadurch gekennzeichnet, daß der Stoff mit kleiner Ladungszahl aus der folgenden Gruppe ausgewählt ist: Kohlenstoff, Aluminium, Silizium, Aluminiumoxid, Siliziumoxid.

15. Gehäuse nach einem der vorstehenden Ansprüche, dadurch gekennzeichnet, daß der Stoff mit hoher Ladungszahl eine Ladungszahl hat, die wenigstens gleich 35 ist.

16. Gehäuse nach einem der vorstehenden Ansprüche, dadurch gekennzeichnet, daß der Stoff mit hoher Ladungszahl eine dielektrische Keramik ist, die aus der Familie der Barium-Strontium-Titanate, aus der Familie der Oxide oder aus der Familie der komplexen Keramiken auf Blei-Basis ausgewählt ist.

**Claims**

1. An enclosure for the encapsulation of an electronic component, comprising a base (3) to receive the component (4) and a cap (1) fixed to the base (3) by the intermediary of a lateral part (2), at least one of the preceding elements comprising at least two layers of distinct materials the said enclosure being characterized in that the first of the distinct materials comprises an element having a high number of atomic charges (Z) in such a manner as to substantially attenuate the radiation and in that the element or elements constituting the second of the distinct materials, situated furthest towards the interior of the enclosure, has or have a low number of charges so as to substantially attenuate the flow of electrons formed in the first material.

2. The enclosure as claimed in claim 1, characterized in that the material furthest towards the exterior has a high number of charges and the other material has a low number of charges.

3. The enclosure as claimed in claim 1, characterized in that the element is the cap.

4. The enclosure as claimed in any one of the preceding claims, characterized in that the first of the materials (11) is an insulating material and the second material (12 and 13) is a conductor of electricity, the second material being arranged in at least two layers, on either side of the first material, the whole forming a capacitor, and in that it comprises a supplementary layer (14), arranged on the internal face thereof and having a low number of charges.

5. The enclosure as claimed in claim 4, characterized in that the two materials are respectively placed on in plurality of alternating layers so as to form a multilayer capacitor.

6. The enclosure as claimed in claim 5, characterized in that the element comprises a supplementary layer, arranged on the external face thereof and made of a material having substantially the same thermal characteristics as the internal supplementary layer.

7. The enclosure as claimed in any one of the preceding claims, characterized in that the element comprises a supplementary layer arranged on the external face thereof and having a high number of charges.

8. The enclosure as claimed in claims 3 and 4, 5, 6 or 7, characterized in that the lateral part (2) thereof is made of a material (11) with a high number of charges and comprising a layer (14) arranged on the internal face thereof and having a low number of charges as compared with the preceding one.

9. The enclosure as claimed in any one of the claims 3 and 4, 5, 6, 7 or 8, characterized in that the base (3) thereof is made of a material whose number of charges is low comprising a layer (33) arranged on the external face thereof with a number of charges high in relation to the preceding one.

10. The enclosure as claimed in claim 9, characterized in that the base (3) furthermore comprises a metallic layer (34) with a low number of charges arranged on its internal face, said layer (34) having the component (4) attached thereto.

11. The enclosure according to claim 9 or claim 10, characterized in that the base (3) comprises inclusions, present in the material with a low number of charges, on its internal and external faces, made of a material with a good thermal conductivity and with a high number of charges.

12. The enclosure as claimed in any one preceding claim, characterized in that the transition between the materials with different numbers of charges is a gradual one.

13. The enclosure as claimed in any one of the preceding claims, characterized in that the material with a low number of charges has a number of charges equal to 20 at the most.

14. The enclosure as claimed in any one of the preceding claims, characterized in that the material with a low number of charges is selected from the group comprising: carbon, aluminum, silicon, alumina and silica.

15. The enclosure as claimed in anyone preceding claim, characterized in that the material with a large number of charges has a number of charges equal to at least 35.

16. The enclosure as claimed in any one of the preceding claims characterized in that the material with a high number of charges is a dielectric ceramic material selected from the titanate family, from the oxide family or from the lead-based complex ceramic family.

FIG_1

FIG_2

FIG_3

FIG_4

FIG_5

FIG_6